# EUROPÄISCHE PATENTSCHRIFT

(11) **EP 3 467 449 B1**
(45) Veröffentlichungstag und Bekanntmachung des Hinweises auf die Patenterteilung: **08.07.2020**
(21) Anmeldenummer: 17195231.0
(22) Anmeldetag: 06.10.2017
(51) Int. Cl.: G01S 7/03, G01S 7/35, G01S 13/42, G01S 13/88, G01F 23/284, G01F 22/00

(54) **RADARFÜLLSTANDMESSGERÄT MIT HOCHFREQUENZVERSTÄRKER**
RADAR FILL LEVEL MEASURING DEVICE WITH HIGH FREQUENCY AMPLIFIER
APPAREIL DE MESURE DE NIVEAU DE REMPLISSAGE À RADAR POURVU D'AMPLIFICATEUR HAUTE FRÉQUENCE

(43) Veröffentlichungstag der Anmeldung: 10.04.2019
(73) Patentinhaber: VEGA Grieshaber KG, 77709 Wolfach (DE)
(72) Erfinder: WELLE, Roland, 77756 Hausach (DE); WÄLDE, Steffen, 78078 Niedereschach (DE)
(74) Vertreter: Maiwald Patent- und Rechtsanwaltsgesellschaft mbH

(56) Entgegenhaltungen:
- EP-A1- 2 824 431
- EP-A1- 3 171 138
- WO-A1-2014/135452
- WO-A1-2016/202394
- DE-A1- 10 051 297
- DE-A1-102015 219 282
- US-A1- 2011 098 970

## Beschreibung

### Gebiet der Erfindung

Die Erfindung betrifft die Füllstandmessung und die Erfassung der Topologie einer Füllgutoberfläche in einem Behälter. Insbesondere betrifft die Erfindung ein Radarfüllstandmessgerät zur Füllstandmessung oder zur Erfassung der Topologie einer Füllgutoberfläche in einem Behälter.

### Hintergrund

Die Füllstandmessung mit Radarfüllstandmessgeräten ist heute Stand der Technik. Im Gegensatz zu vielen anderen Bereichen wurde der Durchbruch für die Radartechnik in der Füllstandmessung erst möglich, nachdem extrem kleine Reflexionssignale von der Elektronik der Messgeräte erfasst und verarbeitet werden konnten.

Moderne Füllstandmessgeräte und Topologiemessgeräte, die in der Lage sind, die genaue Form der Oberfläche eines Füllguts zu erfassen, zeichnen sich nicht nur durch eine hohe Sendefrequenz, die typischerweise im Gigahertzbereich, beispielsweise im Bereich von 75 GHz bis 85 GHz liegt, aus, sondern sind auch in der Lage, Amplitudenunterschiede des reflektierten Signals in einem Bereich bis zu 100 dB sicher zu verarbeiten.

Zur Erzeugung und Verarbeitung der hochfrequenten Sendesignale im Bereich von 79 GHz kann ein monolithisch aufgebauter integrierter Mikrowellenschaltkreis (MMIC) vorgesehen sein. Dieser Baustein kann eine Vielzahl an Sende- und Empfangskanälen aufweisen, die in dieser Anmeldung auch als Radarkanäle bezeichnet werden, so dass die Füllgutoberfläche abgescannt werden kann.

Je genauer die Füllgutoberfläche abgescannt werden soll, desto mehr Sende- und Empfangskanäle sind erforderlich, um eine hochqualitative Abbildung zu erzielen, was mit entsprechend hohem Hardwareaufwand und Energiebedarf einhergeht.

Ein Radarfüllstandmessgerät ist in Dokument EP 3 171 138 A1 offenbart.

### Zusammenfassung der Erfindung

Es ist eine Aufgabe der Erfindung, ein Radarfüllstandmessgerät zum Messen eines Füllstands eines Mediums oder der Topologie eines Mediums in einem Behälter bereitzustellen.

Diese Aufgabe wird durch den Gegenstand des unabhängigen Patentanspruchs gelöst. Weiterbildungen der Erfindung ergeben sich aus den Unteransprüchen und der folgenden Beschreibung.

Ein erster Aspekt der Erfindung betrifft ein Radarfüllstandmessgerät, das zur Messung eines Füllstands eines Mediums in einem Behälter und/oder zur Erfassung der Topologie einer Füllgutoberfläche in dem Behälter eingerichtet ist. Das Radarfüllstandmessgerät weist einen ersten Radarchip und zweiten Radarchip auf. Sowohl der erste Radarchip als auch der zweite Radarchip weisen einen oder mehrere Sendekanäle zum Abstrahlen jeweils eines Sendesignals in Richtung der Füllgutoberfläche und einen oder mehrere Empfangskanäle zum Empfangen der an der Füllgutoberfläche reflektierten Sendesignale auf. Einer oder mehrere der Sendekanäle kann auch als kombinierter Sende-Empfangskanal ausgeführt sein.

Die Radarchips können insbesondere integrierte Mikrowellenschaltkreise sein, welche auch als Radarsystem on Chip bezeichnet werden können. Ein solches Radarsystem on Chip (RSoC) ist ein hochintegrierter Mikrowellenschaltkreis (MMIC) mit Schaltungskomponenten für digitale Funktionen, welches, gemäß einer Ausführungsform, in der Lage ist, die komplette Funktionalität eines herkömmlichen Radarsystems für die Signalerzeugung, die Signalverarbeitung und die Überführung der Empfangssignale, also der reflektierten Sendesignale, in eine digitale Darstellung auf einem einzigen Radarchip zu integrieren.

Jeder der Sendekanäle kann eingerichtet sein, ein hochfrequentes Sendesignal mit einer Frequenz im Gigahertzbereich zu erzeugen, beispielsweise im Bereich von 75 GHz bis 85 GHz oder darüber.

Der erste Radarchip weist eine erste Synchronisationsschaltung auf, welche zur Erzeugung eines Hochfrequenzsignals eingerichtet ist, bei dem es sich im Regelfall um ein Lokaloszillatorsignal des Radarchips handelt. Bei dem Hochfrequenzsignal kann es sich beispielsweise um ein frequenzgeteiltes Signal handeln, das somit eine geringere Frequenz aufweist als das vom Radarfüllstandmessgerät abgestrahlte Sendesignal. Beispielsweise weist das Hochfrequenzsignal eine Frequenz von 40 GHz oder 20 GHz auf.

Der zweite Radarchip weist eine zweite Synchronisationsschaltung auf und es ist eine Hochfrequenzleitungsanordnung vorgesehen, die eingerichtet ist zur Übertragung des Hochfrequenzsignals von der ersten Synchronisationsschaltung an die zweite Synchronisationsschaltung, und welches zur Synchronisation der beiden Radarchips vorgesehen ist. Durch die Frequenzteilung des Hochfrequenzsignals kann die Leiterbahnführung vereinfacht werden, da die Verlustleistung sinkt. Es kann vorgesehen sein, dass das Hochfrequenzsignal wieder vervielfacht wird, bevor es zur Synchronisation der beiden Radarchips eingesetzt wird, beispielsweise durch einen in der zweiten Synchronisationsschaltung angeordneten Frequenzvervielfacher.

Des Weiteren ist ein Hochfrequenzverstärker (oder mehrere davon) vorgesehen, der in der Hochfrequenzleitungsanordnung angeordnet ist und eingerichtet ist zur Verstärkung des Hochfrequenzsignals.

Der erste Radarchip wird als Masterchip bezeichnet werden, der ein Synchronisationssignal erzeugt, mit dessen Hilfe der zweite Chip, der als Slavechip bezeichnet werden wird synchronisiert wird.

Gemäß einer weiteren Ausführungsform der Erfindung ist das Hochfrequenzsignal im Verhältnis zum Sendesignal ein um einen ganzzahligen Faktor geteiltes Hochfrequenzsignal, wie bereits oben angesprochen.

Es kann vorgesehen sein, dass die Verstärkerleistung des oder der in der Hochfrequenzleitungsanordnung angeordneten Hochfrequenzverstärker in Abhängigkeit vom Füllstand eingestellt wird, und/oder beispielsweise in Abhängigkeit davon, wie viele Radarchips momentan für die Füllstandmessung verwendet werden.

Gemäß einer weiteren Ausführungsform der Erfindung weist der Hochfrequenzverstärker einen Nutzfrequenzbereich von 20 GHz auf, oder von 40 GHz.

Gemäß einer weiteren Ausführungsform der Erfindung ist auf dem ersten und/oder dem zweiten Radarchip jeweils ein Analog-Digital-Wandler integriert, eingerichtet zum Umwandeln des Empfangssignals in ein digitalisiertes Zwischenfrequenzsignal, welches auf ein oder mehrere an der Füllgutoberfläche reflektierte Sendesignale zurückzuführen ist.

Gemäß einer weiteren Ausführungsform der Erfindung weisen zumindest zwei der Sendekanäle jeweils eine Antenne auf, die daran angeschlossen ist.

Gemäß einer weiteren Ausführungsform der Erfindung ist das Radarfüllstandmessgerät als FMCW-Radarfüllstandmessgerät ausgeführt, das ein frequenzmoduliertes Dauerstrichsignal zur Messung verwendet, wobei jeder Messzyklus einen Frequenzsweep umfasst, der beispielsweise eine Startfrequenz von 75 GHz aufweist und eine Maximalfrequenz von 85 GHz.

Gemäß einer weiteren Ausführungsform der Erfindung basiert der erste und der zweite Radarchip jeweils auf BiCMOS-Technologie. Gemäß einer weiteren Ausführungsform der Erfindung basieren die Radarchips auf Siliziumgermanium (SiGe)-Technologie. Gemäß einer weiteren Ausführungsform der Erfindung basieren die Radarchips auf HF-CMOS-Technologie und weisen somit Hochfrequenzschaltungsteile für Frequenzen von 75 GHz und darüber auf.

Gemäß einer weiteren Ausführungsform der Erfindung ist das Füllstandmessgerät zum Erfassen der Topologie eines Mediums in einem Behälter ausgeführt, ist also in der Lage, die Füllgutoberfläche durch digitale Strahlumformung abzuscannen.

Gemäß einer weiteren Ausführungsform der Erfindung ist die Hochfrequenzleitungsanordnung mithilfe eines Hochfrequenzleistungsteilers gesplittet und der Hochfrequenzverstärker ist nach dem Hochfrequenzleistungsteiler angeordnet.

Es können auch mehrere Hochfrequenzverstärker vorgesehen sein, wobei einer oder mehrere davon vor einem Leistungsteiler und andere jeweils hinter einem Leistungsteiler angeordnet sind.

Gemäß einer weiteren Ausführungsform der Erfindung handelt es sich bei dem Hochfrequenzverstärker um einen rauscharmen Verstärker (Low Noise Amplifier, LNA) mit separater Spannungsversorgung.

Gemäß einer weiteren Ausführungsform der Erfindung weist das Radarfüllstandmessgerät einen Signalprozessor auf, der eingerichtet ist zum Abschalten des rauscharmen Verstärkers in einer Sendepause des Radarfüllstandmessgeräts, in welcher die Signalverarbeitung und die Berechnung des Füllstands oder der Topologie der Oberfläche des Mediums in dem Behälter durch den Signalprozessor erfolgt. Somit kann Energie gespart werden. Die Aufgaben des Signalprozessors können ebenfalls durch das Prozessorsystem, das im FPGA integriert ist, übernommen werden.

Gemäß einer weiteren Ausführungsform der Erfindung wird dafür gesorgt, dass jeder Hochfrequenzverstärker ausschließlich in seinem linearen Bereich betrieben wird. Gegebenenfalls sind hierfür mehrere Hochfrequenzverstärker in der Hochfrequenzleitungsanordnung vorgesehen.

Gemäß einer weiteren Ausführungsform der Erfindung weist die Hochfrequenzleitungsanordnung eine erste Leiterbahn auf einer Platine, eine zweite Leiterbahn auf der Platine und einen dazwischen angeordneten Hohlleiter auf, der das Hochfrequenzsignal von der ersten Leiterbahn auf die zweite Leiterbahn überträgt. Hierdurch kann die Signaldämpfung herabgesetzt werden.

Im Folgenden werden mit Verweis auf die Figuren Ausführungsformen der Erfindung beschrieben. Werden in der folgenden Figurenbeschreibung dieselben Bezugszeichen verwendet, so bezeichnen diese gleiche oder ähnliche Elemente. Die Darstellungen in den Figuren sind schematisch und nicht maßstäblich.

### Kurze Beschreibung der Figuren

Fig. 1A zeigt ein Radarfüllstandmessgerät, das in einem Behälter installiert ist, um die Topologie der Oberfläche eines Füllguts in dem Behälter zu erfassen.
Fig. 1B zeigt ein weiteres Radarfüllstandmessgerät.
Fig. 1C zeigt ein weiteres Radarfüllstandmessgerät.
Fig. 2 zeigt eine Array-Antenne eines Radarfüllstandmessgeräts.
Fig. 3 zeigt den Aufbau eines Radarfüllstandmessgeräts mit einem Radarchip.
Fig. 4A zeigt den Aufbau eines weiteren Radarfüllstandmessgeräts mit zwei Radarchips.
Fig. 4B zeigt den Aufbau eines weiteren Radarfüllstandmessgeräts.
Fig. 5 zeigt den Aufbau eines weiteren Radarfüllstandmessgeräts.
Fig. 6 zeigt den Aufbau eines weiteren Radarfüllstandmessgeräts.
Fig. 7 zeigt den Aufbau eines weiteren Radarfüllstandmessgeräts.
Fig. 8 zeigt einen Platinenlagenaufbau.
Fig. 9A zeigt eine Via-Anordnung eines Radarfüllstandmessgeräts.
Fig. 9B zeigt die metallisierten Elemente der Via-Anordnung der Fig. 9A.
Fig. 10A zeigt einen Ausschnitt einer Hochfrequenzleitungsanordnung.
Fig. 10B zeigt einen Ausschnitt einer weiteren Hochfrequenzleitungsanordnung.
Fig. 10C zeigt einen Ausschnitt einer weiteren Hochfrequenzleitungsanordnung.
Fig. 11 zeigt eine weitere Hochfrequenzleitungsanordnung.
Fig. 12 zeigt eine weitere Hochfrequenzleitungsanordnung.
Fig. 13A zeigt die Draufsicht auf eine weitere Hochfrequenzleitungsanordnung.
Fig. 13B zeigt die Unterseite der Platine der Leitungsanordnung der Fig. 13A.

### Detaillierte Beschreibung von Ausführungsformen

Ein Vorteil von mehrkanaligen Radarchips 301 besteht darin, dass eine Strahlformung durchgeführt werden kann. Unter dem Begriff Radarchip kann ein hochintegrierter Radarchip verstanden werden, der mehrere Sende- und Empfangskanäle ausweist. In diesem Zusammenhang kann man auch von einem Radarsystem on Chip sprechen (RSoC).

Derartige RSoCs 301 werden bei der Füllstandmessung eingesetzt. Es kann ein die Topologie einer Füllgutoberfläche erfassendes Füllstandmessgerät 101 bereitgestellt werden, das die Oberfläche von Schüttgütern abtastet, um dadurch mehr Informationen über den tatsächlichen Füllstand und dessen Volumen zu erhalten, wie man es bei einer klassischen Füllstandmessung erhalten würde.

Hierfür werden auch in großer Distanz noch kleine Öffnungswinkel benötigt, was mit einer großen Antennenapertur einhergeht.

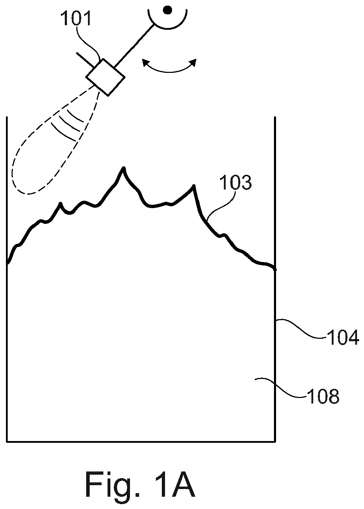

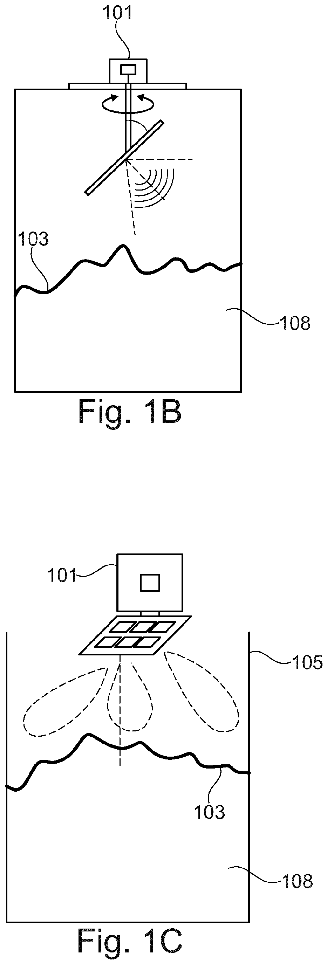

Eine Möglichkeit, dies zu erreichen, ist es, ein Ein-Kanal-Radargerät 101 mechanisch zu schwenken (Figur 1A), um so die Oberfläche 103 eines Füllguts 108 in einem Behälter 104 abzutasten. Eine weitere Möglichkeit sind teilmechanische Systeme (Figur 1B). Dort wird eine Kombination aus analoger oder digitaler Strahlformung mit einem mechanischen Schwenken kombiniert.

Nachteile haben diese Systeme hinsichtlich Robustheit. Mechanikkomponenten sind in rauen Prozessbedingungen wartungsanfällig und in der Herstellung teuer. Deshalb gibt es die Möglichkeit, eine vollelektronische Strahlformung durchzuführen (Figur 1C).

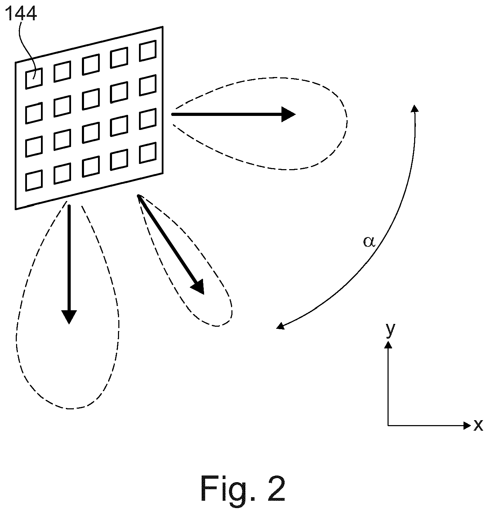

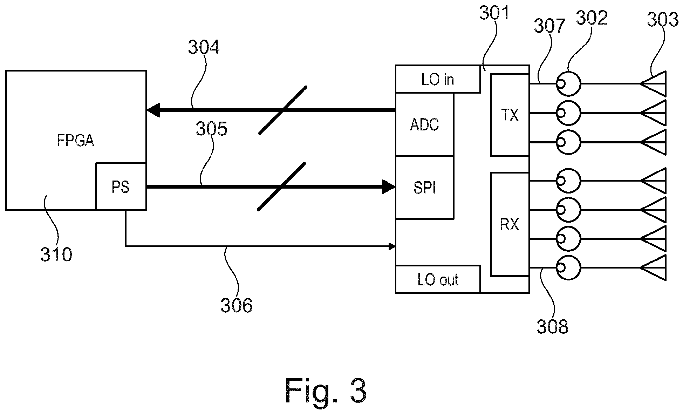

Um mit diesen Beamforming-Radarsystemen vergleichbar große Antennenaperturen zu erreichen, sollte eine große Anzahl an Sendern und Empfängern vorgesehen sein. Der Nachteil an der vollelektronischen Strahlformung ist, dass viele Antennen mit verhältnismäßig kleiner Einzelapertur verwendet werden müssen. Außerdem müssen Sender und Empfänger, die üblicherweise mit jeweils einem Antennenelement 144, 303 versehen werden, in zwei Dimensionen (x- und y-Richtung) aufgereiht werden (Figur 2, Figur 3).

Für die topologieerfassende Füllstandmesstechnik werden deshalb üblicherweise mehr Sender und Empfänger als in obigen Anwendungen benötigt, was in einer Chipanzahl größer vier resultiert.

Die Topologie einer Füllgutoberfläche erfassende Radarfüllstandmessgeräte weisen meist mehrere Sende- und Empfangsantennen auf. Diese Systeme werden auch als MIMO-Systeme (Multiple Input Multiple Output) bezeichnet. Durch entsprechende Verfahren der digitalen Strahlformung können sowohl sende- als auch empfangsseitig die Richtcharakterisika der Sende- und Empfangsgruppenantenne digital beeinflusst werden, wodurch die Abtastung einer Füllgutoberfläche realisiert werden kann.

Diese Füllstandmessgeräte verwenden bisher für jeden Sende- und Empfangskanal mehrere diskrete Hochfrequenzbauelemente, wie Mischer, Low Noise Amplifier, Koppler, Frequenzvervielfacher, spannungsgesteuerte Oszillatoren etc. sowie diskrete Analog-/Digitalwandler, Phasenregelschleifen, Spannungsregler, Filter, Verstärker und weitere Niederfrequenzbauelemente. Diese Eigenschaft macht MIMO-Systeme aufwändig, groß und teuer.

Hochintegrierte Radarchips 301 (vgl. Figur 3) haben viele dieser oben genannten Komponenten bereits vollständig auf einem Chip 301 integriert. Bereits integriert sind: PLL, VCO, Mischer, ADCs, Filter, Steuerungseinheiten, SPI Schnittstelle, Verstärker, Schalter, Spannungsregler. Dadurch kann viel Platz auf einer Leiterkarte gespart werden. Ein weiterer Vorteil bieten diese Chips 301 hinsichtlich Kosten, da diese günstiger sind als ein diskreter Aufbau mit mehreren verschiedenen Einzelkomponenten.

Die MIMO-Chips 301 haben beispielsweise drei Sender- und vier Empfängerstufen 307, 308 mit jeweils einer Antenne 303. Ein möglicher Sendefrequenzbereich kann beispielsweise zwischen 55 und 65 GHz oder aber auch zwischen 75 und 85GHz liegen.

Die Radarchips 301 können über eine digitale Schnittstelle (mit zugehörigem Bus (305)) (SPI, I²C, etc.) parametriert werden. Es können verschiedene Parameter gesetzt oder ausgelesen werden um die Modulationsart, Bandbreite, Frequenzbereich, Abtastfrequenz, ZF-Filtercharakteristika (Zwischenfrequenzsignal), etc. einzustellen. Üblicherweise werden die analogen ZF-Signale, die Informationen über Abstände und Winkel von Objekten aus dem Überwachungsbereich beinhalten, ebenfalls noch auf dem Radarchip 301 für die weitere Signalverarbeitung digitalisiert.

Das Radarverfahren, nach welchem diese Radarchips 301 üblicherweise arbeiten, ist ein spezielles frequenzmoduliertes Dauerstrichradarverfahren (FMCW-Verfahren, frequency modulated continous wave). Es wird bei einer Messung jedoch nicht nur eine Frequenzrampe moduliert, sondern mehrere hintereinander, die in einem festen Zeitbezug zueinander stehen. Eine mögliche Anzahl an Rampen pro Messung ist beispielsweise 128. Diese 128 Rampen zusammengefasst werden als Frame bezeichnet.

Durch geschickte Signalverarbeitungsalgorithmen lassen sich neben Abständen auch Geschwindigkeiten von mehreren Objekten bestimmen. Die Rampendauer ist im Verhältnis zum klassischen FMCW-Verfahren sehr kurz und liegt üblicherweise im Bereich zwischen 10 und 500µs pro Rampe. Da die HF-Bandbreite der Sendesignale im Bereich zwischen mehreren Hundert Megahertz und vier (oder mehr) Gigahertz liegen kann, muss das Zwischenfrequenzsignal mit hoher Abtastrate digitalisiert werden.

Die Kombination aus hoher HF-Bandbreite und kurzen Rampendauern, resultiert in einer hohen Abtastrate bei der Analog-Digital-Wandlung.

Die Schnittstelle für die digitalisierten Ausgangssignale ist meist eine schnelle serielle, differentielle Digitalschnittstelle 304 wie LVDS oder CSI2. Beim Beispiel eines Radarchips 301 mit vier Empfangskanälen weist der Radarchip 301 seitens der Digitalschnittstelle vier LVDS- bzw. CSI2-Schnittstellen auf, über die das digitalisierte Zwischenfrequenzsignal übertragen wird. Zusätzlich verwenden diese Digitalschnittstellen ein zusätzliches differentielles Clock-Signal, das beim Empfänger der digitalisierten Daten zur Synchronisation der Schnittstellen benötigt wird. Je nach Schnittstelle werden noch weitere Signalleitungen benötigt um Anfang und/oder Ende der Datenpakete zu kennzeichnen.

Im Fall, dass der Radarchip 301 für die gewünschte Applikation dennoch zu wenig Sende- und Empfangskanäle liefert, bieten diese Chips 301 die Möglichkeit einer Kaskadierung. Das bedeutet, dass mehrere Chips zu einer synchronisierten Radareinheit zusammengefasst werden. Somit wird es möglich Sender gleichzeitig mit einem synchronen Signal senden zu lassen und/oder Empfänger synchron Empfangen zu lassen obwohl diese sich physikalisch auf unterschiedlichen RSoCs befinden.

Das wird möglich indem neben verschiedenen Taktsynchronisationsleitungen ebenfalls ein Hochfrequenzsignal auf einer Hochfrequenzleitung 401 ausgehend von einem Chip an andere Chips verteilt wird. Das Hochfrequenzsignal wird als Lokaloszillatorsignal (LO-Signal) bezeichnet und ist vom Frequenzbereich her in Bezug auf den Sendefrequenzbereich um einen ganzzahligen Faktor geteiltes Signal. Möglich sind die Teilerfaktoren zwei oder vier aber auch andere ganzzahlige Teilerfaktoren. Hat der Radarchip beispielsweise einen Sendefrequenzbereich um 80 GHz, so kann das LO-Signal einen Frequenzbereich um 20 GHz oder 40 GHz aufweisen.

Der Radarchip, der das Hochfrequenzsignal bereitstellt wird, als Master 301a bezeichnet. Die Chips, die das Hochfrequenzsignal empfangen, werden als Slaves 301b bezeichnet.

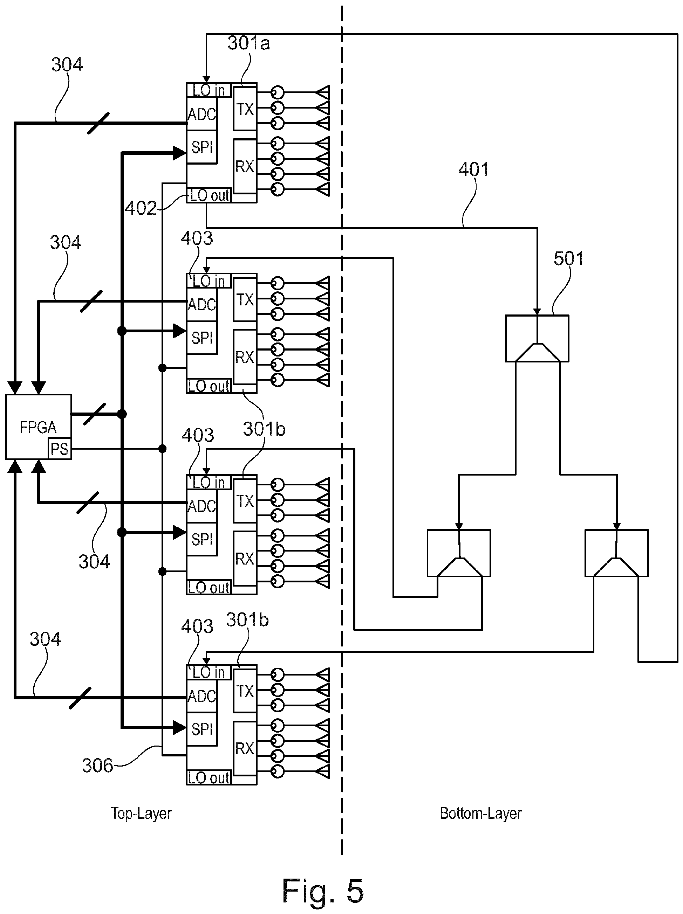

Beispielsweise hat ein kaskadiertes Radarsystem, das vier Radarchips beinhaltet (Figur 5), die wiederum jeweils vier Empfangskanäle aufweisen, sechzehn Digitalschnittstellen über die die zugehörigen Zwischenfrequenzsignale (Messdaten) übertragen werden.

Bestimmte Radarchips verwenden zur Verarbeitung dieser digitalen Messdaten meist speziell angepasste Signalprozessoren, die jedoch eine stark begrenzte Anzahl von Digitalschnittstellen aufweisen. Teilweise sind auf dem Radarchip selbst Einheiten zur digitalen Signalverarbeitung integriert, was aber für eine Kaskadierung von Radarchips und im Kontext der radarbasierten, topologiebestimmenden Füllstandmessung nur begrenzt nützlich ist oder gar nicht verwendet werden kann.

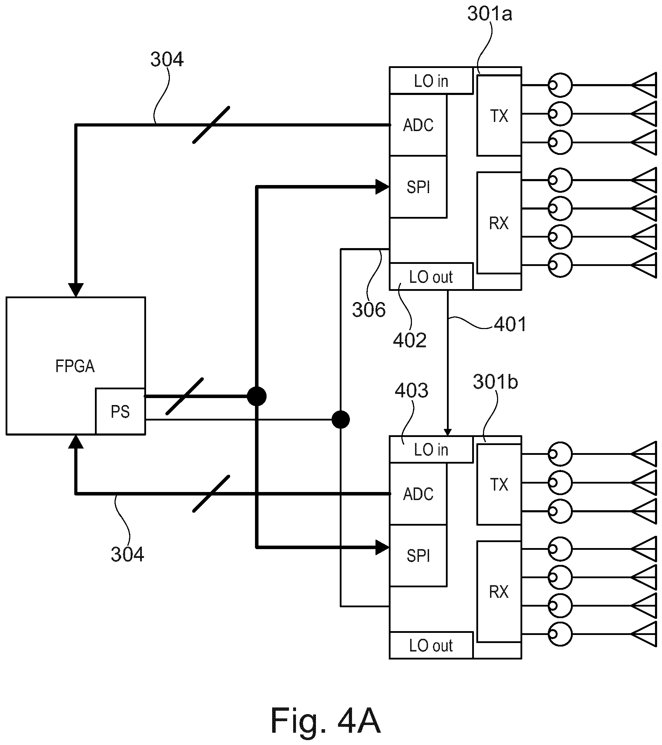

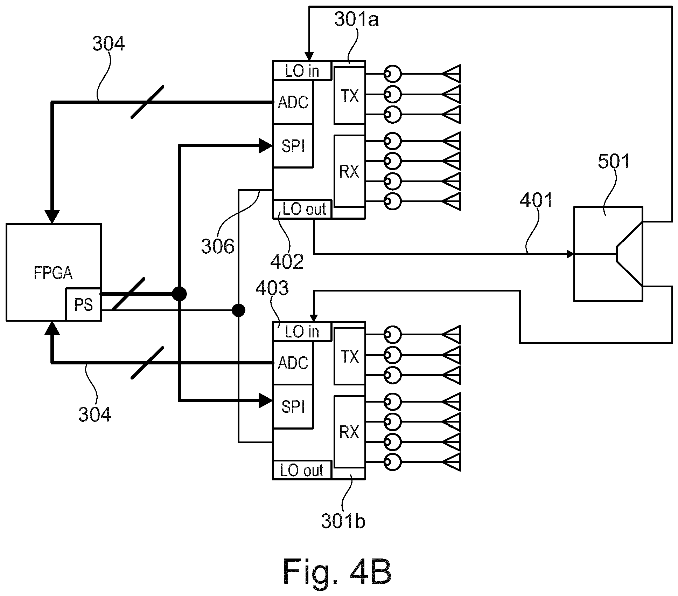

Deshalb wird zur Umgehung dieses Problems vorgeschlagen, anstelle dem speziell angepassten Signalprozessor einen FPGA Baustein (Field Programmable Gate Array 310) zu verwenden (Figuren 3, 4A, 4B und 5). Diese universell einsetzbaren Bausteine, sind von einigen wenigen Herstellern in verschiedenen Ausführungsformen erhältlich. Das FPGA empfängt die digitalisierten Werte des Zwischenfrequenzsignals und übernimmt Rechenoperationen wie Mittelung, Fensterung oder die Berechnung von FFTs (Fast Fourier Transformation).

Vorteilhaft an der Kombination aus Radarchips und FPGA ist eine flexible Kombination von acht oder mehr Radarchips, die mit einem speziell angepassten Signalprozessor, wie er in der Automobilindustrie verwendet wird nicht möglich wäre. Durch die Kaskadierung einer solch großen Anzahl von Radarchips wird diese Technologie für die Füllstandmesstechnik interessant.

Wird eine weit größere Anzahl an Radarchips benötigt, ist es möglich, ebenfalls mehrere FPGAs zu verwenden und diese dann ebenfalls untereinander zu synchronisieren.

In vorteilhafter Weise beinhaltet das FPGA neben den programmierbaren Logikzellen ein integriertes Prozessorsystem (PS) das Steuerungsaufgaben, wie die Parametrierung der Radarchips, das Energiemanagement, die Ansteuerung eines Displays oder die Kommunikation mit einem Computer oder einer Prozessleitstelle über ein Netzwerk übernehmen kann. Ebenfalls kann das Prozessorsystem über eine Digitalleitung 306 den Start einer Messung signalisieren.

Weiterhin kann das Prozessorsystem Signalverarbeitungsaufgaben, wie sie bei anderen Füllstandradarmessgeräten bekannt sind, wie Echosuche, Störechoausblendung, etc. übernehmen.

Je nach Art des Radarchips und des FPGAs kann es notwendig sein eine Pegelanpassung der Digitalschnittstellen vorzunehmen. Hierfür kann ein speziell angepasstes Widerstandsnetzwerk oder ein Anpassungschip verwendet werden.

Eine weitere Ausführungsform, die in vorteilhafter Weise verwendet werden kann, weist die Verwendung eines oder mehrerer Verstärker mit integriertem Splitter für Niederfrequenzsignale auf, die, ausgehend vom Master, den Start einer Messung signalisieren. Der Master sendet dieses Signal aus und verteilt es an alle Slaves. Wichtig dabei ist, dass die Leitungen in etwa die gleiche Länge aufweisen, damit es keine Zeitversätze in den einzelnen Radarchips gibt.

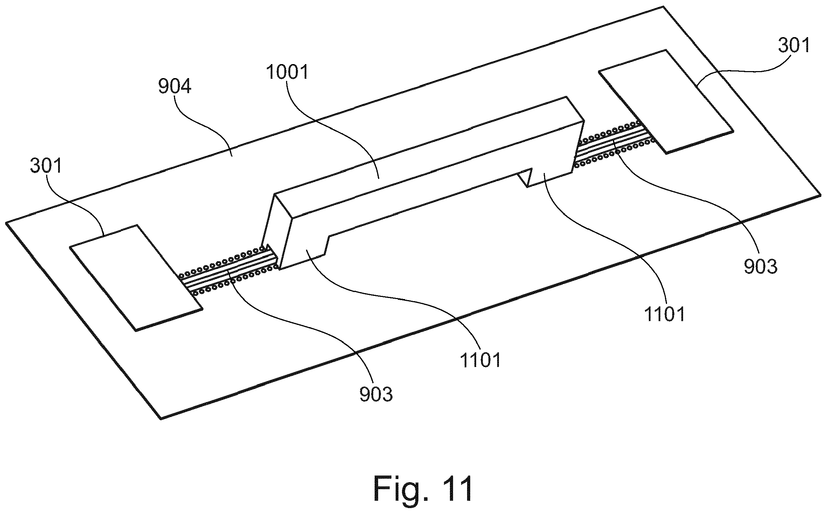

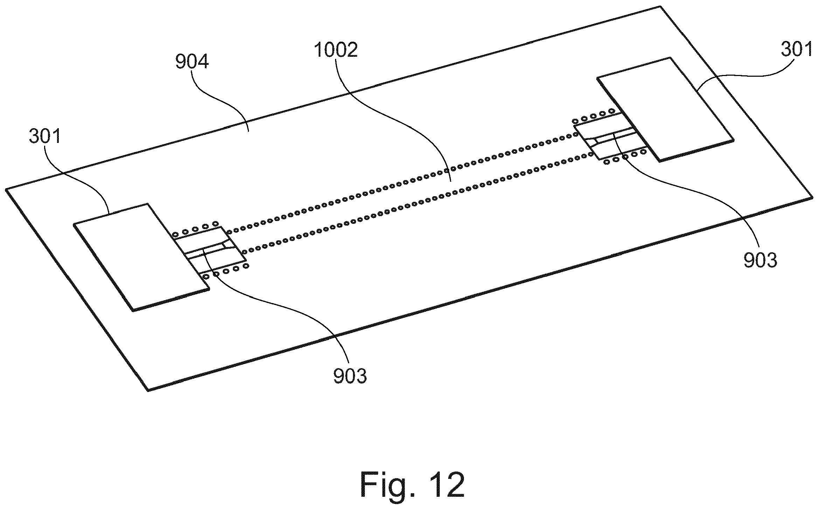

Da auf diese Art und Weise eine größere Menge an Radarchips kaskadiert werden kann, kann es vorkommen, dass die Ausgangsstufe des LO-Signals nicht ausreichend Ausgangsleistung liefert um alle Radarchips zu treiben. Problematisch an der Verteilung des LO-Signals auf der Hochfrequenzleitung 401 ist, dass Hochfrequenzleitungen eine nicht zu vernachlässigbare Streckendämpfung aufweisen. Da die Radarchips 301 auf der Platine 904 meist mehrere Zentimeter (Größenordnung: 5-10 cm) räumlich voneinander getrennt sind, müssen die Hochfrequenzleitungen 401, die das LO-Signal führen mindestens genau so lang sein. Eine typische Mikrostreifenleitung auf einem Standard-Hochfrequenz-Substrat kann eine Dämpfung von 0,5 bis 2 dB / cm aufweisen. Dies ist hauptsächlich substrat- und frequenzabhängig. Hohlleiter hingegen können so aufgebaut werden, dass sie eine weitaus geringere Streckendämpfung besitzen. Aus diesem Grund macht es Sinn, nachdem das LO-Signal auf die Platine (904) mittels einer Mikrostreifenleitung ausgekoppelt wurde, das Signal in einen Hohlleiter einzukoppeln um weniger Verluste auf der Wegstrecke zum benachbarten Chip einzufahren (schematisch dargestellt in den Figuren 11 und 12).

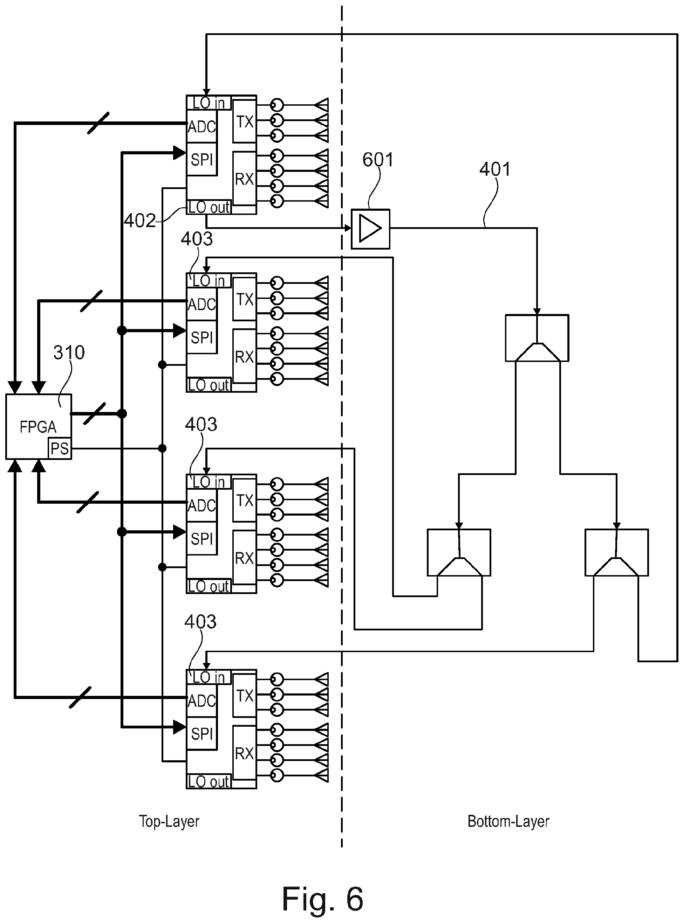

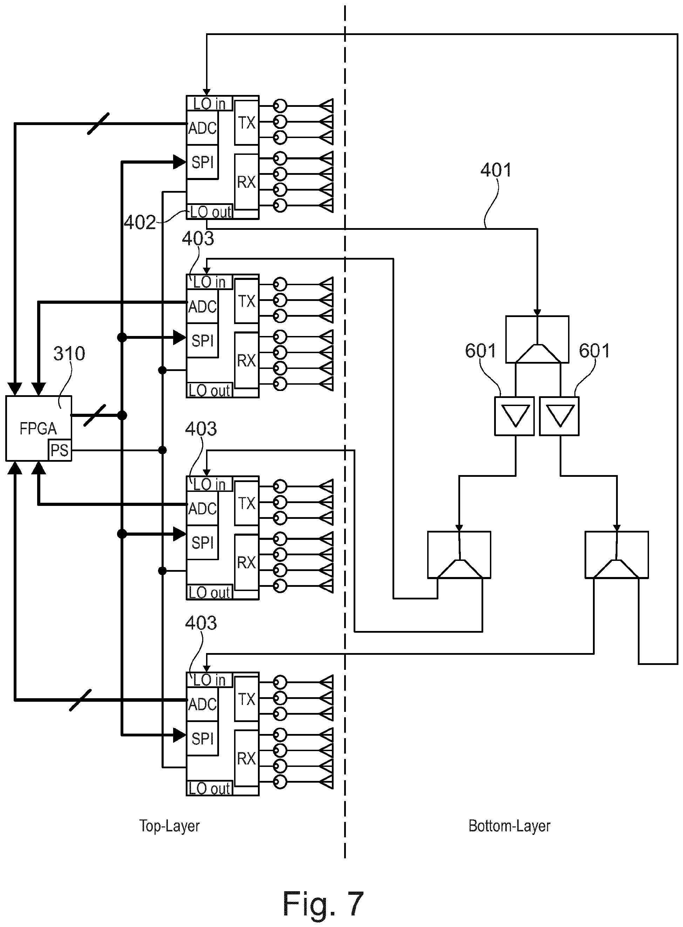

Eine weitere Möglichkeit bieten sich an, indem ein oder mehrere externe Hochfrequenzverstärker 601 eingesetzt werden um die HF-Leistung des LO-Signals auf der Hochfrequenzleitung 401 zu verstärken (Figur 6 und 7). In vorteilhafter Weise haben diese Verstärker eine geringe Rauschzahl (Noise Figure), da diese direkt auf die Systemperformance Auswirkung hat. Deshalb werden hierfür rauscharme Verstärker (engl. Low Noise Amplifiers LNAs) vorgeschlagen.
Diese LNAs sind aktive Bauelemente mit separater Spannungsversorgung. In vorteilhafter Weise werden diese zwischen den Radarframes und/oder in Sendepausen abgeschaltet um Energie zu sparen und um eine zu starke Erwärmung des Geräts zu vermeiden.

Weiterhin muss darauf geachtet werden, dass die LNAs in ihrem linearen Bereich betrieben werden, was bedeutet, dass die Eingangsleistung des Hochfrequenzsignals nicht zu groß ist. Ist dies der Fall kann es zu Signalverzerrungen kommen. Technologiebedingt liegen typische Ausgangsleistungen von Halbleiterbauelementen bei 80 GHz zwischen 8 und 15 dBm, ohne dass es zu wesentlichen Signalverzerrungen kommt.

Würde ein Hochfrequenzverstärker 601 mit 20 dB Gain mit einem Hochfrequenzsignal mit einer Leistung von 15 dBm gespeist werden, ergäbe sich eine Ausgangsleistung von 35 dBm. Da der Hochfrequenzverstärker 601 dann aber nicht mehr in seinem linearen Bereich arbeiten würde, würde es zu unerwünschten Signalverzerrungen kommen. Deshalb sollte das LO-Signal zunächst in einen Leistungsbereich gebracht werden, damit der Hochfrequenzverstärker 601 in seinem linearen Bereich arbeiten kann.

Es gibt die Möglichkeit, die LO-Ausgangsleistung der Radarchips 301 zu parametrieren und somit zu dämpfen. Ebenfalls kann eine lange Hochfrequenzleitung die Ausgangsleistung ebenfalls dämpfen.

Beispielsweise können die Hochfrequenzverstärker auch erst eingesetzt werden, nachdem das LO-Signal mithilfe eines Hochfrequenzleistungsteilers geteilt und somit in der Leistung niedriger gemacht wurde. Das ist der Fall, wenn mehrere Slaves 301b zum Einsatz kommen oder wenn je nach Radarchip 301 das LO-Signal wieder in den Master 301a zurückgeführt werden muss.

Dann können mehrere Verstärker eingesetzt werden, wie in Figur 7 zu sehen ist. Da ein Verstärker ebenfalls eine endliche Signaldurchlaufzeit hat, werden in vorteilhafter Weise die Verstärker so platziert, dass sich auf allen Leitungen im Wesentlichen die gleiche Signallaufzeit einstellt.

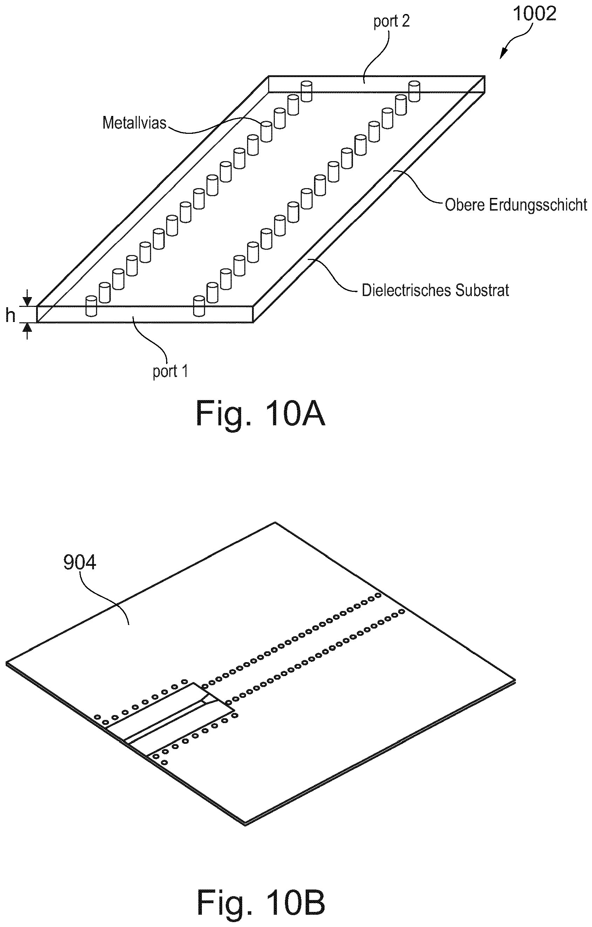

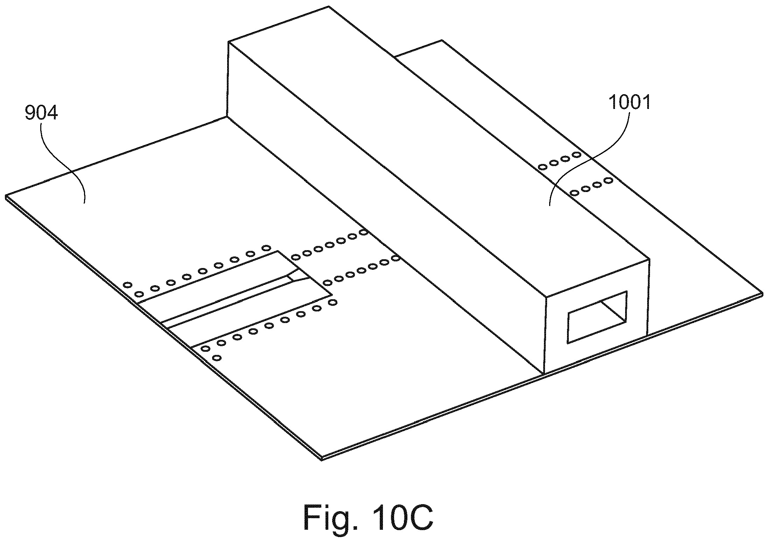

Da es sich beim LO-Signal um ein Hochfrequenzsignal handelt, können in vorteilhafter Weise Hohlleiter, Mikrostreifenleiter 903 und/oder SIW-Leitungen (Substrate Integrated Waveguide) 1002 (Figur 10) verwendet werden. Ebenfalls können zur Aufsplittung der Leitung in vorteilhafter Weise Leistungsteiler 501 (z.B. Wilkinson-Divider) und/oder Koppler 501 (z.B. Rat-Race-Koppler) verwendet werden.

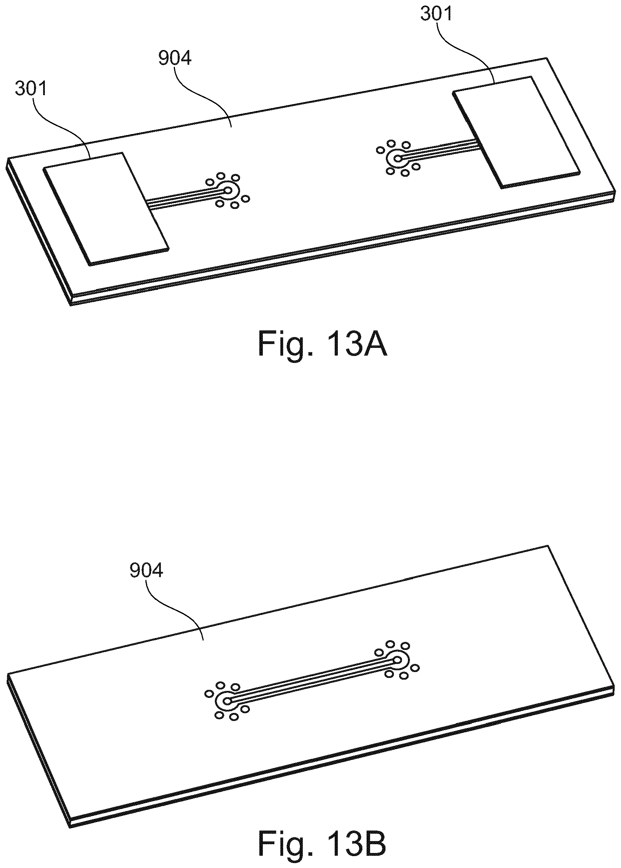

In vorteilhafter Weise können die Radarchips auf der einen Seite der Platine 904 platziert werden und die Aufsplittung und Verteilung des LO-Signals geschieht dann auf der anderen Seite der Platine 904, so wie in den Figuren 5 bis 7 und ebenfalls in den Figuren 13A und 13B dargestellt. Die Ursache hierfür wird im Folgenden erläutert.

Die Radarchips besitzen meist neun oder zehn Signaleingänge und Signalausgänge deren Frequenzbereich im zweistelligen Gigahertzbereich liegt. Bei der Kaskadierung der Radarchips müssen neben den Leitungen zu den Sende- und Empfangsantennen noch die LO-Signale von Chip zu Chip geroutet werden. Durch diese Vielzahl an Signalleitungen sind Kreuzungen von Signalen oftmals unausweichlich.

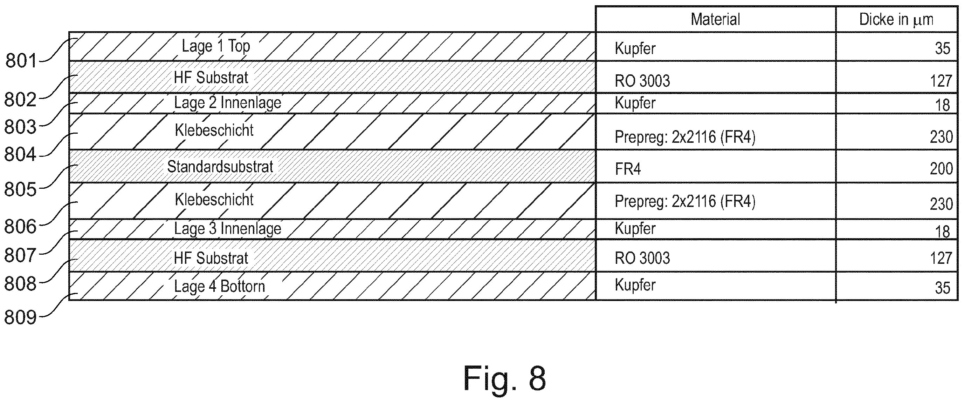

Da jedoch Kreuzungen von Signalleitungen auf einer Platine 904 nicht möglich sind, werden die Signale üblicherweise mit Vias in andere innenliegende Platinenebenen (Innenlagen) 803, 807 geleitet und dort aneinander vorbeigeführt. Ein typischer Platinenlagenaufbau ist in Figur 8 zu sehen, wobei mehrere Substrate mit einer Klebefolie 804, 806 zusammengeklebt werden. Meist sind Innenlagen von Platinen 904 jedoch Standardsubstratmaterialien 804, 805, 806 und nicht für Hochfrequenzsignale geeignet. Aus Kosten- und Stabilitätsgründen werden nämlich oftmals nur eine oder beide der äußersten Substratlagen 802, 808 einer Platine 904 aus speziellem für die Hochfrequenztechnik optimiertem Substratmaterial (beispielsweise Rogers RO3003) aufgebaut. Hochfrequenzsubstrate sind in der Regel weich und werden bei hohen Frequenzen oft sehr dünn ausgeführt, wie in Figur 8 mit 127 µm beschrieben. Die äußeren Lagen 801, 804 sind metallisierte Schichten.

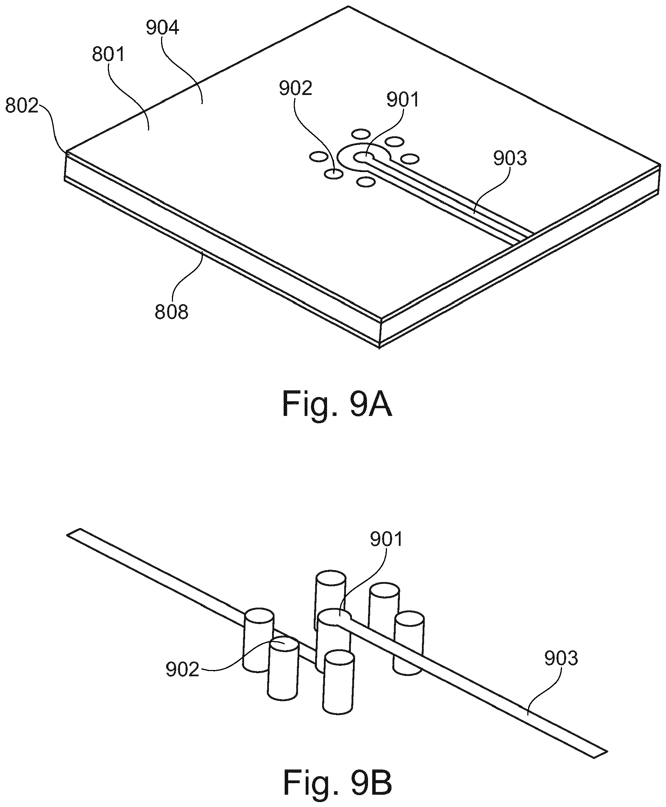

Aus diesen Gründen wird vorgeschlagen, mit speziellen Leitungsstrukturen und Via-Anordnungen das LO-Signal von der chipseitigen Platinenebene auf die Rückseite zu führen, dort zu splitten, ggf. zu verstärken und zu verteilen und wieder auf die chipseitige Platinenebene aufzutauchen. Solche speziellen Leitungsstrukturen und Via-Anordnungen sind in Figuren 9A und 9B zu sehen (Figur 9B zeigt die Leitung und Vias ohne die Substratmaterialien und Kupferflächen). Dabei werden um das Hauptvia 901 weitere Nebenvias 902 in einem konstanten Radius platziert und bilden so eine Art koaxiale Leiterplattendurchführung. Viadurchmesser und Abstand zum Hauptvia bestimmen maßgeblich die Impedanz der Durchführung und muss auf den verwendeten Frequenzbereich von beispielsweise 40 GHz angepasst werden.

Eine alternative Möglichkeit, die LO-Signale ohne Kreuzung der Leitungen zu routen ist, das Signal in einen Hohlleiter oder ein Koaxialkabel einzukoppeln und die Hohlleiter bzw. Koaxialkabel so aufzubauen, dass die Leitungen aneinander vorbeiführen. Um beispielsweise in einen Hohlleiter einzukoppeln, kann ein Übergang von Mikrostreifenleitung auf Hohlleiter 1101 verwendet werden.

Ein ebenfalls nützlicher Leitungstyp ist der Substrate Integrated Waveguide (SIW) (Figur 10A). Dieser Leitungstyp wird in vorteilhafter Weise dann verwendet, wenn beispielsweise ein Hohlleiter 1001 direkt auf einer Leiterkarte/Platine 904 aufliegt auf der ein LO-/HF-Signal mittels Mikrostreifenleitung unter dem Hohlleiter hindurchgeroutet werden muss. Da der Hohlleiter meist aus einem Metall besteht, würde er die Mikrostreifenleitung kurzschließen, was eine Signalübertragung unmöglich macht. Hier bietet der SIW Vorteile, da dieser auf der Platinenoberseite eine reine Metallfläche aufweist und es keine Rolle spielt ob ein Hohlleiter darüber liegt (siehe Figur 10C). Ein Übergang von Mikrostreifenleitungstechnik auf SIW ist in Abbildung 10B gezeigt.

Anschließend muss das Signal wieder auf die Platine (904) in eine Mikrostreifenleitung eingekoppelt werden, um in den Radarchip geroutet werden zu können.

Auszeichnend für Radarfüllstandmessgeräte sind robuste Antennenvorrichtungen, die bei rauen Prozessbedingungen wie hohe und niedrige Drücke, hohen und tiefen Temperaturen, Schmutz, Staub, Feuchtigkeit, Nebel, etc. noch funktionieren. Hinzu kommt, dass die Antennen ebenfalls die Elektronik vor obigen Einflüssen schützen müssen und zusätzlich so konstruiert sein, dass sie ebenfalls sicherheitskritische Aspekte wie Explosionsschutz erfüllen müssen.

So sollten auch bei vielen topologieerfassenden Radarfüllstandmessgeräten diese Eigenschaften gegeben sein. Anders als bei anderweitig verwendeten Radargeräten, bei denen solche Anforderungen nicht so hoch sind, werden in der Prozessmesstechnik häufig Hohlleiter und Hornstrahler verwendet.

Es ist bei Systemen zur digitalen Strahlformung vorteilhaft, wenn ein oder mehrere Antennenelemente einen Abstand ≤ λ/2 aufweisen, wobei λ die Wellenlänge des Sendesignals bezeichnet. Für solche Fälle können spezielle Hohlleitereinkopplungen (302) verwendet werden, um das Signal von einer Leiterkarte in eine (Horn-)Antenne (303) einzukoppeln.

Eine weitere Herausforderung bei die Topologie erfassenden Radarfüllstandmessgeräten mit kaskadierten Radarchips ist es, dass die oben beschriebenen Antennen nur in bestimmten Mustern angeordnet werden dürfen. Ein vorteilhaftes Muster wäre eine T- oder L-förmige Anordnung der Antennenelemente. Um bei den Hochfrequenzsignalen große Leitungslängen zu vermeiden, wird vorgeschlagen die Radarchips auf der Platinen-Ober- und Unterseite zu platzieren damit die Leitungslängen von Radarchip zu Hohlleitereinkopplung für alle HF-Signale etwa gleich lang ist.

Ein Kerngedanke der Erfindung kann darin gesehen werden, dass ein die Topologie der Füllgutoberfläche erfassendes Radarfüllstandmessgerät 101 bereitgestellt wird, welches aus mehreren integrierten Radarchips 301 besteht oder diese zumindest aufweist, wobei die Radarchips 301 mit einem Hochfrequenzsignal (Lokaloszillatorsignal), das von einer Synchronisationsschaltung 402 eines der Radarchips 301a generiert und auf einer Hochfrequenzleitung 401 an eine Synchronisationsschaltung 403 des zweiten Radarchips 301b geführt wird, miteinander synchronisiert werden, und wobei ein oder mehrere Hochfrequenzverstärker 601 das Lokaloszillatorsignal des Radarchips 301a verstärken.

Ergänzend sei daraufhingewiesen, dass "umfassend" und "aufweisend" keine anderen Elemente oder Schritte ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen anzusehen.

## Patentansprüche

1. Radarfüllstandmessgerät (101) zur Füllstandmessung oder zur Erfassung der Topologie einer Füllgutoberfläche in einem Behälter, aufweisend:
einen ersten Radarchip (301a) und einen zweiten Radarchip (301b),
wobei der erste Radarchip (301a) als Masterchip eine erste Synchronisationsschaltung (402) aufweist, welche zur Erzeugung eines Hochfrequenzsignals eingerichtet ist;
wobei der zweite Radarchip (301b) als Slavechip eine zweite Synchronisationsschaltung (403) aufweist;
eine Hochfrequenzleitungsanordnung (401), eingerichtet zur Übertragung des Hochfrequenzsignals von der ersten Synchronisationsschaltung an die zweite Synchronisationsschaltung zur Synchronisation der beiden Radarchips;
einen Hochfrequenzverstärker (601), der in der Hochfrequenzleitungsanordnung angeordnet ist und eingerichtet ist zur Verstärkung des Hochfrequenzsignals.

2. Radarfüllstandmessgerät (101) nach Anspruch 1,
wobei das Hochfrequenzsignal im Verhältnis zum Sendesignal ein um einen ganzzahligen Faktor geteiltes Hochfrequenzsignal ist.

3. Radarfüllstandmessgerät (101) nach einem der vorhergehenden Ansprüche, wobei der Hochfrequenzverstärker (601) einen Nutzfrequenzbereich von über 30 GHz aufweist.

4. Radarfüllstandmessgerät (101) nach einem der vorhergehenden Ansprüche, wobei auf dem ersten und dem zweiten Radarchip (301a, 301b) jeweils ein Analog / Digitalwandler integriert ist.

5. Radarfüllstandmessgerät (101) nach einem der vorhergehenden Ansprüche, wobei die Hochfrequenzleitungsanordnung (401) mithilfe eines Hochfrequenzleistungsteilers (501) gesplittet ist und der Hochfrequenzverstärker (601) nach dem Hochfrequenzleistungsteiler angeordnet ist.

6. Radarfüllstandmessgerät (101) nach einem der vorhergehenden Ansprüche, wobei der Hochfrequenzverstärker (601) ein rauscharmer Verstärker mit separater Spannungsversorgung ist.

7. Radarfüllstandmessgerät (101) nach einem der vorhergehenden Ansprüche, weiter aufweisend ein Field Programmable Gate Array (310), eingerichtet zum Abschalten des rauscharmen Verstärkers (601) in einer Sendepause des Radarfüllstandmessgeräts, in welcher die Signalverarbeitung und die Berechnung des Füllstands oder der Topologie der Oberfläche des Mediums in dem Behälter durch den Field Programmable Gate Array (310) erfolgt.

8. Radarfüllstandmessgerät (101) nach einem der vorhergehenden Ansprüche, wobei die Hochfrequenzleitungsanordnung (401) mehrere rauscharme Hochfrequenzverstärker (601) mit separater Spannungsversorgung aufweist.

9. Radarfüllstandmessgerät (101) nach einem der vorhergehenden Ansprüche, wobei die Hochfrequenzleitungsanordnung (401) eine erste Leiterbahn (903) auf einer Platine (904), eine zweite Leiterbahn (903) auf der Platine und einen dazwischen angeordneten Hohlleiter (1001) aufweist.

10. Radarfüllstandmessgerät (101) nach einem der vorhergehenden Ansprüche, eingerichtet zur Erfassung der Topologie eines Mediums in einem Behälter.

11. Radarfüllstandmessgerät (101) nach einem der vorhergehenden Ansprüche, wobei der erste Radarchip (301a) und der zweite Radarchip (301b) jeweils einen oder mehrere Sendekanäle (307) zum Abstrahlen jeweils eines Sendesignals und einen oder mehrere Empfangskanäle (308) zum Empfangen jeweils der an der Füllgutoberfläche reflektierten Sendesignale aufweisen.

12. Radarfüllstandmessgerät (101) nach einem der vorhergehenden Ansprüche, wobei das Füllstandmessgerät (100) als Füllstandmessgerät unter Verwendung eines frequenzmodulierten Dauerstrichradarverfahrens ausgeführt ist.

## Claims

1. A radar fill level measuring device (101) for fill level measurement or for detecting the topology of a fill medium surface in a container, comprising:
a first radar chip (301a) and a second radar chip (301b),
wherein the first radar chip (301a) as a master chip comprises a first synchronization circuit (402) adapted to generate a radio frequency signal;
wherein the second radar chip (301b) as a slave chip comprises a second synchronization circuit (403);
a high-frequency line arrangement (401) adapted to transmit the high-frequency signal from the first synchronizing circuit to the second synchronizing circuit for synchronizing the two radar chips;
a high-frequency amplifier (601) arranged in said high-frequency line arrangement and adapted to amplify said high-frequency signal.

2. The radar fill level measuring device (101) according to claim 1,
wherein the high-frequency signal in relation to the transmitted signal is a high-frequency signal divided by an integer factor.

3. The radar fill level measuring device (101) according to any one of the preceding claims,
wherein the high-frequency amplifier (601) has a useful frequency range of more than 30 GHz.

4. The radar fill level measuring device (101) according to any one of the preceding claims,
wherein an analog-to-digital converter is integrated on each of the first and second radar chips (301a, 301b).

5. The radar fill level measuring device (101) according to any one of the preceding claims,
wherein the high frequency line arrangement (401) is split by means of a high frequency power divider (501) and the high frequency amplifier (601) is arranged after the high frequency power divider.

6. The radar fill level measuring device (101) according to any one of the preceding claims,
wherein the high frequency amplifier (601) is a low noise amplifier with separate power supply.

7. The radar fill level measuring device (101) according to any one of the preceding claims,
further comprising a Field Programmable Gate Array (310) adapted to switch off the low-noise amplifier (601) in a transmission pause of the radar level gauge, in which signal processing and calculation of the level or topology of the surface of the medium in the container is performed by the Field Programmable Gate Array (310).

8. The radar fill level measuring device (101) according to any one of the preceding claims,
wherein the high frequency line arrangement (401) comprises a plurality of low noise high frequency amplifiers (601) with separate power supply.

9. The radar fill level measuring device (101) according to any one of the preceding claims,
wherein the high frequency line arrangement (401) comprises a first conductor track (903) on a board (904), a second conductor track (903) on the board and a waveguide (1001) disposed therebetween.

10. The radar fill level measuring device (101) according to any one of the foregoing, adapted to detect the topology of a medium in a container.

11. The radar fill level measuring device (101) according to any one of the preceding claims,
wherein the first radar chip (301a) and the second radar chip (301b) each have one or more transmission channels (307) for emitting in each case one transmission signal and one or more reception channels (308) for receiving in each case the transmission signals reflected at the fill medium surface.

12. The radar fill level measuring device (101) according to any one of the preceding claims,
wherein the level measuring device (100) is designed as a fill level measuring device using a frequency-modulated continuous wave radar method.

## Revendications

1. Appareil de mesure de niveau de remplissage par radar (101) pour la mesure d'un niveau de remplissage ou pour la détection de la topologie de la surface d'un produit de remplissage dans un récipient, présentant :
une première puce radar (301a) et une deuxième puce radar (301b),
la première puce radar (301a) présentant, en tant que puce maîtresse, un premier circuit de synchronisation (402) conçu pour générer un signal haute fréquence ;
la deuxième puce radar (301b) présentant, en tant que puce esclave, un deuxième circuit de synchronisation (403) ;
un agencement de ligne haute fréquence (401) conçu pour transmettre le signal haute fréquence du premier circuit de synchronisation au deuxième circuit de synchronisation pour synchroniser les deux puces radar ;
un amplificateur haute fréquence (601) qui est disposé dans l'agencement de ligne haute fréquence et conçu pour amplifier le signal haute fréquence.

2. Appareil de mesure de niveau de remplissage par radar (101) selon la revendication 1,
dans lequel le signal haute fréquence est, par rapport au signal d'émission, un signal haute fréquence divisé par un facteur entier.

3. Appareil de mesure de niveau de remplissage par radar (101) selon l'une des revendications précédentes,
dans lequel l'amplificateur haute fréquence (601) présente une gamme de fréquences utiles supérieure à 30 GHz.

4. Appareil de mesure de niveau de remplissage par radar (101) selon l'une des revendications précédentes,
dans lequel un convertisseur analogique-numérique est intégré sur chacune des première et deuxième puces radar (301a, 301b).

5. Appareil de mesure de niveau de remplissage par radar (101) selon l'une des revendications précédentes,
dans lequel l'agencement de ligne haute fréquence (401) est divisé au moyen d'un diviseur de puissance haute fréquence (501) et l'amplificateur haute fréquence (601) est disposé après le diviseur de puissance haute fréquence.

6. Appareil de mesure de niveau de remplissage par radar (101) selon l'une des revendications précédentes,
dans lequel l'amplificateur haute fréquence (601) est un amplificateur à faible bruit avec une alimentation électrique séparée.

7. Appareil de mesure de niveau de remplissage par radar (101) selon l'une des revendications précédentes,
présentant en outre un Field Programmable Gate Array (310) conçu pour désactiver l'amplificateur à faible bruit (601) dans une pause d'émission de l'appareil de mesure de niveau de remplissage par radar, dans lequel le traitement de signal et le calcul du niveau de remplissage ou de la topologie de la surface du milieu dans le récipient sont effectués par le Field Programmable Gate Array (310).

8. Appareil de mesure de niveau de remplissage par radar (101) selon l'une des revendications précédentes,
dans lequel l'agencement de ligne haute fréquence (401) présente plusieurs amplificateurs haute fréquence à faible bruit (601) avec une alimentation électrique séparée.

9. Appareil de mesure de niveau de remplissage par radar (101) selon l'une des revendications précédentes,
dans lequel l'agencement de ligne haute fréquence (401) présente une première piste conductrice (903) sur une carte de circuit imprimé (904), une deuxième piste conductrice (903) sur la carte de circuit imprimé et un guide d'ondes (1001) disposé entre elles.

10. Appareil de mesure de niveau de remplissage par radar (101) selon l'une des revendications précédentes,
conçu pour détecter la topologie d'un milieu dans un récipient.

11. Appareil de mesure de niveau de remplissage par radar (101) selon l'une des revendications précédentes,
dans lequel la première puce radar (301a) et la deuxième puce radar (301b) présentent chacune un ou plusieurs canaux d'émission (307) pour émettre à chaque fois un signal d'émission et un ou plusieurs canaux de réception (308) pour recevoir à chaque fois les signaux d'émission réfléchis à la surface du produit de remplissage.

12. Appareil de mesure de niveau de remplissage par radar (101) selon l'une des revendications précédentes,
dans lequel l'appareil de mesure de niveau de remplissage (100) est réalisé sous la forme d'un appareil de mesure de niveau de remplissage utilisant un procédé de radar à ondes entretenues modulées en fréquence.
